(19) Europäisches Patentamt
European Patent Office
Office européen des brevets

(11) **EP 1 657 759 B1**

(12) **FASCICULE DE BREVET EUROPEEN**

(45) Date de publication et mention
de la délivrance du brevet:
**18.06.2008 Bulletin 2008/25**

(51) Int Cl.:
*H01L 41/06* (2006.01)    *F02D 41/20* (2006.01)
*H02N 2/06* (2006.01)

(21) Numéro de dépôt: **05300870.2**

(22) Date de dépôt: **27.10.2005**

(54) **Procédé de commande d'un actionneur magnétostrictif, dispositif commandable en position mettant en oeuvre le procédé**

Verfahren zur Ansteuerung eines magnetostriktiven Aktors sowie positionssteuerbare Vorrichtung zur Durchführung des Verfahrens

Method for driving a magnetostrictive actuator and position-controllable apparatus for carrying out the method

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **16.11.2004 FR 0452634**

(43) Date de publication de la demande:
**17.05.2006 Bulletin 2006/20**

(73) Titulaire: **RENAULT S.A.S.**
**92100 Boulogne Billancourt (FR)**

(72) Inventeurs:
• **Guerbaoui-Defremont, M. Samir Eugène**
**75017 Paris (FR)**
• **Ripoll, M. Christophe**
**78220 Viroflay (FR)**

(56) Documents cités:
**EP-A- 0 924 589**        **EP-A- 1 420 468**
**WO-A-01/71823**        **DE-A1- 4 413 240**
**US-A- 4 585 978**

**Description**

La présente invention concerne un procédé de commande d'un actionneur magnétostrictif ainsi qu'un dispositif commandable en position, pour mettre en oeuvre un tel procédé notamment pour un moteur thermique à explosion.

Dans l'état de la technique représenté notamment par le document EP-A-1.420.468, on a déjà décrit un procédé de commande d'un actionneur magnétostrictif appliqué à la réalisation d'un injecteur pour un dispositif d'injection de moteur thermique à explosion. Particulièrement, il a été décrit un procédé de commande d'un circuit de commutation en pont destiné à alimenter électriquement l'actionneur magnétostrictif de façon à produire une forme d'onde d'alimentation adaptée à sa commande d'ouverture et/ou de fermeture.

La présente invention permet de rendre un tel dispositif commandable en position. Il peut être adapté à différents actionneurs comme un injecteur, ou une soupape dans un moteur à explosion.

Les actionneurs magnétostrictifs sont généralement constitués par une partie électrique, de type inductif, couplée par un effet magnétostrictif à une partie mécanique qui permet de déplacer, en rotation ou linéairement selon la géométrie de l'actionneur, une partie mécanique mobile relativement à une partie mécanique fixe. Cependant, les actionneurs magnétostrictifs ne permettent pas simplement de conserver une position de travail fixe à la partie mécanique mobile sauf si la partie électrique inductive reçoit une alimentation électrique correcte qui assure le maintien de cette position. L'activation d'un actionneur magnétostrictif comporte donc :

    -- une étape de mobilisation faisant passer la partie mécanique mobile d'une position de repos à une position de travail ;
    -- une étape de maintien de la position de travail de la partie mécanique mobile ; et
    -- une étape de retour de la partie mécanique mobile de la position de travail à la position de repos relativement à la partie mécanique fixe.

Dans le document cité EP-A-1.420.468, on a déjà décrit la nécessité que la forme d'onde d'alimentation électrique appliquée à la partie électrique de l'actionneur magnétostrictif lors de l'étape de maintien de sa position de travail soit de la forme :

$$F(t) = D1 * (1 + \cos(2*\pi*t/T))$$

qui exprime que la forme d'onde appliquée à la partie électrique inductive de l'actionneur magnétostrictif comporte une seule harmonique de fréquence 1/T et une composante continue de valeur D1, l'une et l'autre de même amplitude.

Selon la présente invention, il est prévu que la composante continue de la forme d'onde d'alimentation de la partie électrique inductive, déterminée a priori, soit adaptée instantanément en fonction de la réponse mécanique et/ou électrique de l'actionneur magnétostrictif. En effet, la présente invention concerne un procédé de commande d'un actionneur magnétostrictif du genre comportant une partie électrique, notamment de type inductif, et qui est destinée à être alimentée électriquement et une partie mécanique dont une partie mécanique mobile peut être maintenue dans une position de travail relativement à une partie mécanique fixe, le procédé comportant les étapes de :

    -- détecter le courant électrique traversant la partie électrique de l'actionneur magnétostrictif;
    -- modifier l'amplitude et/ou la fréquence de la forme d'onde d'alimentation électrique en fonction de la détection du courant électrique traversant la partie électrique de l'actionneur ;

en répétant le procédé pendant au moins une partie d'une étape de maintien de la position de travail de la partie mécanique mobile de l'actionneur magnétostrictif.

L'invention concerne aussi un dispositif de contrôle d'un actionneur magnétostrictif **caractérisé en ce** qu'il comporte :

    -- un pont d'alimentation électrique comportant au moins un composant actif et connecté, d'une part, à une source de tension électrique et, d'autre part, à la partie électrique de l'actionneur magnétostrictif ;
    -- un capteur pour détecter le courant électrique traversant la partie électrique de l'actionneur magnétostrictif ;
    -- un calculateur pour commander les composants actifs du pont d'alimentation électrique en fonction du signal produit par le capteur pour détecter le courant électrique traversant la partie électrique de l'actionneur magnétostrictif de façon à adapter l'amplitude et/ou la fréquence de la forme d'onde d'alimentation électrique de l'actionneur magnétostrictif.

D'autres **caractéristiques et** avantages de la présente invention seront mieux compris à l'aide de la description et des dessins parmi lesquels :

-    la figure 1 représente un schéma de principe d'un mode particulier de réalisation d'un dispositif de contrôle d'un actionneur magnétostrictif selon l'invention ;
-    la figure 2 représente neuf chronogrammes (2a) à (2e) de signaux mesurés sur le dispositif de la figure 1, lors de l'exécution du procédé de l'invention ;
-    les figures 3 à 11 représentent diverses topologies du circuit de pilotage de la figure 1.

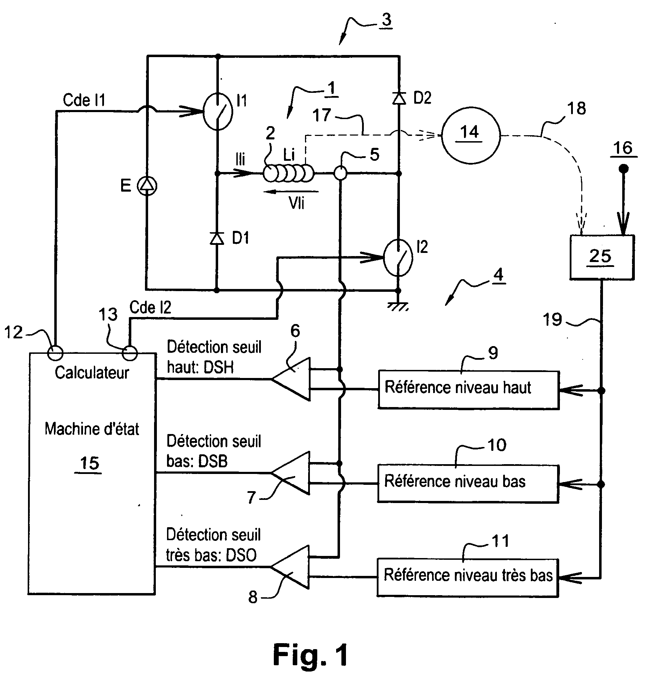

À la figure 1, on a représenté le schéma de principe d'un mode particulier de réalisation d'un dispositif de contrôle d'un actionneur magnétostrictif selon l'invention. L'actionneur magnétostrictif 1 présente une inductance d'entrée 2 qui est connectée dans un pont d'alimentation 3, alimenté par une source de tension continue E, comme la batterie du réseau de bord d'un véhicule à bord duquel le dispositif de l'invention est installé. Le pont d'alimentation 3 présente une première diagonale comportant un premier interrupteur commandé I1 connecté à une première borne de l'inductance 2 dont une seconde borne est connectée à un second interrupteur commandé I2. Le pont d'alimentation 3 présente une seconde diagonale comportant une première diode d1 dont la cathode est connectée à ladite première borne de l'inductance 2, et une seconde diode d2 dont l'anode est connectée à la seconde borne de l'inductance 2.

Chaque interrupteur commandé I1, I2 comporte une électrode de commande qui est connectée à des circuits de sortie 12,13 d'un calculateur 15 qui exécute une machine d'état qui sera décrite plus loin. Le signal de commande Cde I1 ou Cde I2 déterminé par la machine d'état du calculateur 15 permet de contrôler l'état ouvert ou fermé de chacun des deux interrupteurs commandés.

Le dispositif de la figure 1 comporte ensuite un capteur de courant 5 dont le signal de détection analogique est transmis à des premières bornes d'entrée d'un ensemble de circuits comparateurs 6 -- 8, et dont le signal de sortie est connecté à des bornes d'entrée convenables du calculateur 15 pour être pris en compte par la machine d'état exécutée sur le calculateur 15. Les secondes bornes d'entrée de l'ensemble de circuits comparateurs 6 -- 8 sont connectées à des circuits générateurs de référence de comparaison 9 -- 11 qui seront décrit plus loin.

Dans un mode particulier de réalisation, l'ensemble des circuits comparateurs 6--8 permet de détecter trois niveaux de tension sur le signal de détection produit par le capteur 5 :

-- un signal de détection de seuil haut DSH produit sur la base d'un signal de référence de niveau haut produit par le générateur 9 sur le comparateur 6 ;
-- un signal de détection de seuil bas DSB produit sur la base d'un signal de référence de niveau bas produit par le générateur 10 sur le comparateur 7 ; et
-- un signal de détection de seuil très bas DSO produit sur la base d'un signal de référence de niveau très bas produit par le générateur 11 sur le comparateur 8.

D'une manière générale le procédé de l'invention comporte une étape de détection du courant électrique de l'actionneur magnétostrictif. Lors de cette étape, on exécute la détection du passage d'un niveau de courant très bas à travers la partie électrique de l'actionneur, à l'issue de laquelle on exécute l'étape de modification de la forme d'onde d'alimentation.

Lors de l'étape de détection du courant électrique de l'actionneur magnétostrictif, une étape de détection du passage d'un niveau de courant bas, supérieur à un niveau de courant très bas, et de détection du passage d'un niveau de courant haut à travers la partie électrique de l'actionneur est exécutée. Puis, l'étape de modification de la forme d'onde d'alimentation comporte une étape pour augmenter le niveau de courant si on détecte un niveau de courant bas et pour diminuer le niveau de courant si on détecte un niveau de courant haut.

Le procédé comporte une étape pour modifier l'amplitude et/ou la fréquence de la forme d'onde d'alimentation de la partie électrique.

À la figure 1, on a aussi représenté l'action de la partie mécanique mobile sur sa partie mécanique fixe associée dans le cadre de l'actionneur magnétostrictif contrôlé par le dispositif de contrôle selon le procédé de l'invention. L'actionneur magnétostrictif 2,14 agit sur d'autres mécanismes comme, par exemple, les soupapes d'un système d'admission ou d'échappement, les injecteurs d'un dispositif d'injection de moteur thermique.

Le mécanisme sur lequel agit l'actionneur magnétostrictif 2,14 peut coopérer dans une boucle 18 avec un calculateur utilisateur 25, comme l'ordinateur de bord d'un véhicule ou le calculateur d'injection, qui peut recevoir les commandes du poste de conduite 16. Le calculateur utilisateur 25 produit alors une consigne 18 en fonction des missions que l'actionneur magnétostrictif 2,14 doit exécuter sur le mécanisme à contrôler. La consigne 18 est alors convertie en commande de fixation des différentes références de niveau 9--11.

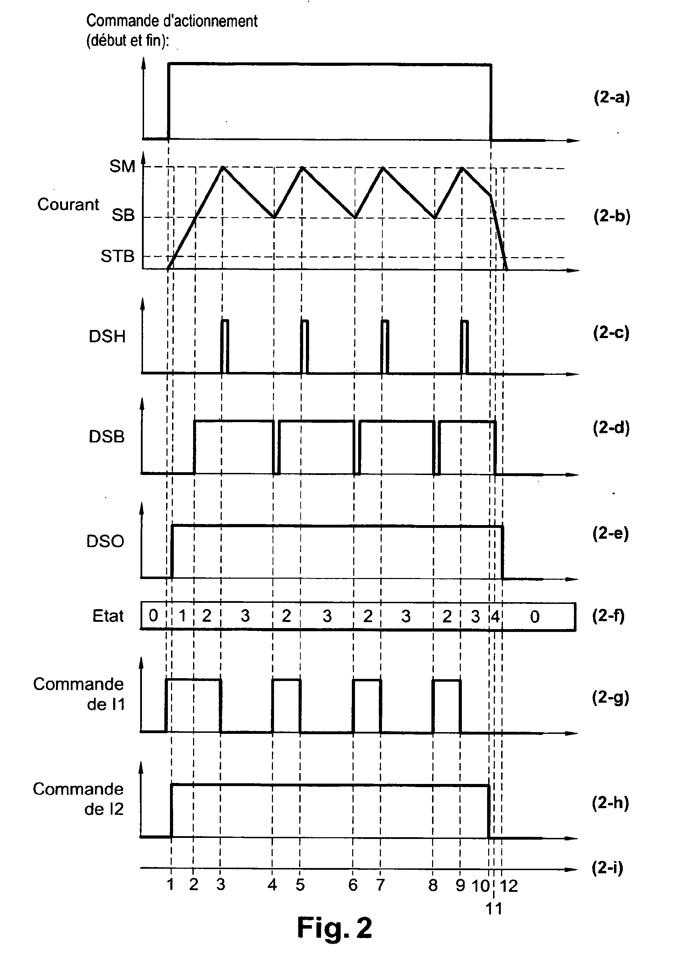

A la figure 2, on a représenté neuf chronogrammes de signaux mesurés sur le dispositif de la figure 1, lors de l'exécution du procédé de l'invention. Lorsque le contrôleur reçoit un ordre d'actionnement de l'actionneur magnétostrictif, le signal représenté à la figure 2a présente une partie de transition montante, puis une partie active et enfin une transition descendante entre les instants 1 et 10 représentés au diagramme 2i. Pendant la période de signal actif, le contrôleur est activé sur une composante continue correspondant à une position de travail ainsi qu'il a déjà été expliqué ci-dessus.

Pendant au moins une partie de cette période active, de façon à moduler le courant représenté par la forme d'onde du chronogramme de la figure 2b, l'interrupteur I1 et l'interrupteur I2 sont commandés par la machine d'état exécutée sur le contrôleur 15 selon les chronogrammes 2g et 2h en fonction des états de la machine d'état représentés au chronogramme 2f et synthétisés à l'aide des trois chronogrammes 2c à 2e.

Au chronogramme 2e, le signal de détection d'état DSO passe à l'état haut dès que le courant détecté (chronogramme 2b) dépasse le seuil très bas STB. Le signal de détection d'état DSO passe à l'état bas dès que le courant détecté (chronogramme 2b) redescend sous le seuil très bas STB à l'instant 12 (chronogramme 2i).

On va maintenant décrire la machine d'état qui est exécutée pour contrôler le fonctionnement de l'actionneur magnétostrictif. D'une manière générale, le calculateur associé à l'actionneur magnétostrictif est connecté au circuit C de détection du niveau de courant et il comporte un moyen pour exécuter une machine d'état 15 reproduisant les étapes du procédé, le pont d'alimentation étant contrôlé en fonction de l'exécution de la machine d'état.

Dans un mode particulier de réalisation, la machine d'état peut prendre six états successifs qui sont désignés de l'état 0 à l'état 5. L'état 5 est un état dans laquelle se place la machine d'état lorsque le contrôleur détecte un défaut en plaçant notamment un indicateur d'état à la valeur active. Lorsque le contrôleur applique un signal de réinitialisation, la machine d'état placée à l'état 5 passe alors à l'état 0.

Dans l'état 0, les interrupteurs I1 et I2 sont ouverts. Le changement d'état est commandé par la transition d'un état inactif à un état actif de l'indicateur de mise en conduction ON produit par le contrôleur. Dans ce cas, la machine d'état passe de l'état 0 à l'état 1 dans lequel les interrupteurs I1 et I2 sont tous les deux placés en conduction.

Dans l'état 1, lorsque le signal de mise en conduction ON passe de l'état actif à l'état inactif, la machine d'état passe de l'état 1 à un état 4 qui sera décrit plus loin. Dans l'état 1, si l'indicateur de détection du seuil bas DSB est à "1", la machine d'état passe de l'état 1 à l'état 2.

Dans l'état 2, les interrupteurs I1 et I2 sont fermés. Lorsque le contrôleur détecte l'arrivée du courant traversant l'actionneur à un seuil haut, sur transition du signal DSH, la machine d'état passe de l'état 2 à l'état 3.

Dans l'état 3, l'interrupteur I1 est ouvert et l'interrupteur I2 est en conduction. Si le signal de détection de seuil bas DSB passe de l'état 1 à l'état 0, la machine d'état repasse de l'état 3 à l'état 2. Si le signal de mise en conduction ON passe d'un état 1 à l'état 0, la machine d'état repasse de l'état 3 à l'état 4 qui sera décrit plus loin.

Dans l'état 4, les deux interrupteurs I1 et I2 sont placés à l'état ouvert. Si le signal de détection de seuil très bas DS0 passe à l'état 0, la machine d'état passe de l'état 4 à l'état 0.

Dans l'état 5, les deux interrupteurs I1 et I2 sont placés à l'état ouvert.

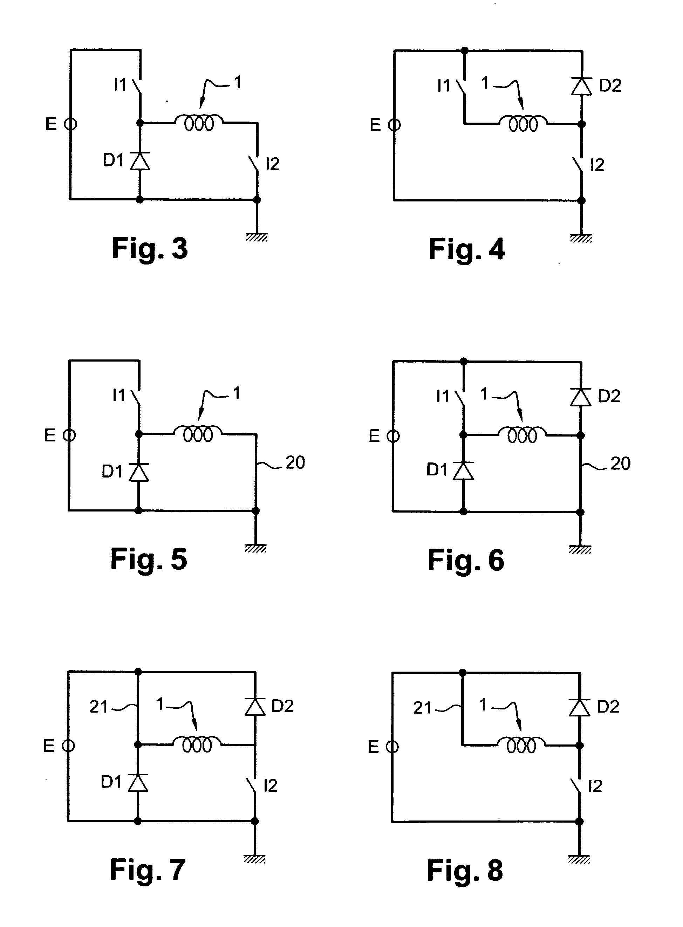

D'autres structures de pilotage de l'actionneur magnétostrictif sont possibles. Elles sont résumées dans les figures 3 à 11. En général, le pont d'alimentation comporte au moins un interrupteur contrôlé comme l'interrupteur I1, ou encore une paire d'interrupteurs I1, I2. Il comporte au moins une diode D1 ou une paire de diodes D1, D2. Il comporte au moins trois branches, la quatrième branche étant alors constituée par un circuit ouvert et dans certaines topologies, une ou deux branches du pont pouvant être constituées par un court-circuit.

À la figure 3, on a représenté une topologie modifiée du circuit de pilotage représenté à la figure 1. Dans ce circuit de pilotage, le pont est constitué par trois branches identiques au pont du circuit la figure 1, mais dans lequel la seconde diode D2 est remplacée par un circuit ouvert.

À la figure 4, on a représenté une topologie modifiée du circuit de pilotage représenté à la figure 1. Dans ce circuit de pilotage, le pont est constitué par trois branches identiques au pont du circuit de la figure 1, dans lequel la première diode D1 est remplacée par un circuit ouvert.

À la figure 5, on a représenté une topologie modifiée du circuit de pilotage représenté à la figure 1. Dans ce circuit de pilotage, le pont est constitué par trois branches identiques au pont du circuit de la figure 3, dans lequel le second interrupteur I2 est remplacé par un court-circuit 20.

À la figure 6, on a représenté une topologie modifiée du circuit de pilotage représenté à la figure 1. Dans ce circuit de pilotage, le pont est constitué par trois branches identiques au pont du circuit de la figure 1, dans lequel le second interrupteur I2 est remplacé par un court-circuit 20.

À la figure 7, on a représenté une topologie modifiée du circuit de pilotage représenté à la figure 1. Dans ce circuit de pilotage, le pont est constitué par trois branches identiques au pont du circuit de la figure 1, dans lequel le premier interrupteur I1 est remplacé par un court-circuit 21.

À la figure 8, on a représenté une topologie modifiée du circuit de pilotage représenté à la figure 1. Dans ce circuit de pilotage, le pont est constitué par trois branches identiques au pont du circuit de la figure 7, dans lequel la première diode D1 est remplacée par un circuit ouvert.

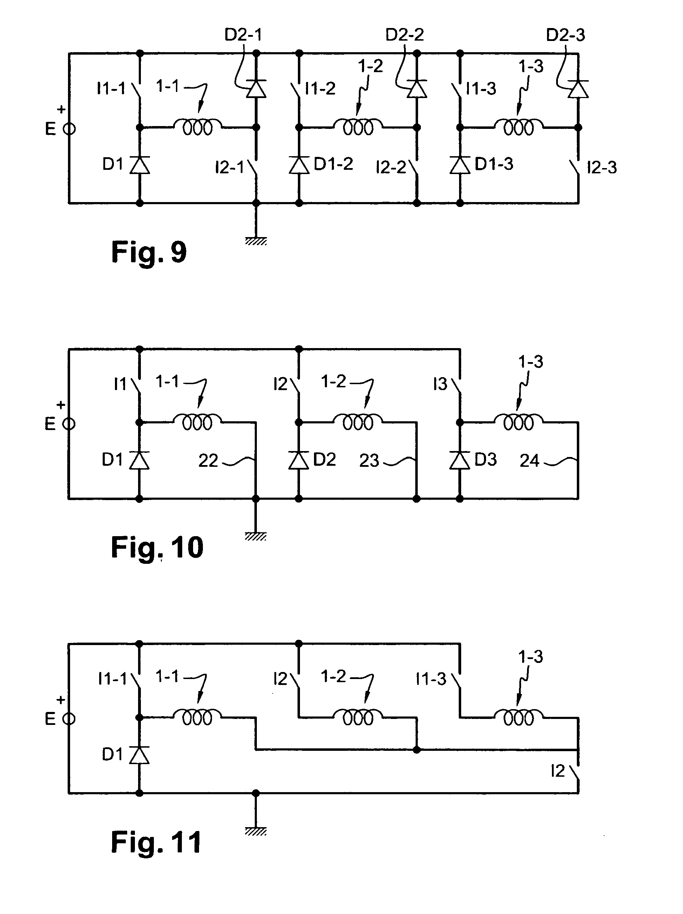

Aux figures 9 à 11, on a représenté des topologies modifiées et adaptées à un nombre déterminé d'actionneurs magnétostrictifs, représentés au dessin par trois actionneurs magnétostrictifs. Un nombre plus élevé est bien entendu possible. Dans ce cas, le dispositif de l'invention comporte une pluralité de parties électriques d'actionneurs, chacune étant connectée par au moins une première et une seconde branches de pont d'alimentation à une première et une seconde bornes de la source d'alimentation.

À la figure 9, les trois actionneurs 1--1, 1--2, 1--3 sont respectivement alimentés par un pont identique au pont du circuit de pilotage représenté à la figure 1. Chaque composant du pont correspondant à l'élément semblable du pont de la figure 1 est repéré avec le même chiffre de référence augmentée de l'indice correspondant au rang du circuit de pilotage considéré. Plus généralement, cette structure nécessite deux fois plus d'interrupteurs qu'il comporte d'actionneurs magnétostrictifs.

À la figure 10, on a représenté une topologie modifiée et adaptée à trois actionneurs magnétostrictifs dans laquelle chaque actionneur est connecté par un court-circuit 22, 23, 24 au point neutre du circuit, tandis que l'autre borne de l'actionneur est connectée au point milieu d'une branche de pont comportant respectivement un interrupteur I1, I2 ou I3 et une diode D1, D2 ou D3. Dans cette topologie modifiée et adaptée, cette structure nécessite autant d'interrupteurs et de diodes qu'elle comporte d'actionneurs magnétostrictifs.

À la figure 11, on a représenté une topologie modifiée et adaptée à trois actionneurs magnétostrictifs dans laquelle chaque actionneur magnétostrictif 1--1, 1--2, 1--3 est connecté en étoile à la masse à travers un unique interrupteur I1, tandis que chaque autre borne de chaque actionneur est connectée à l'alimentation positive par l'intermédiaire d'un interrupteur I1--1, I1--2 ou I1--3. La première branche du pont est connectée à la masse par l'intermédiaire d'une diode D1. Dans cette topologie modifiée et adaptée, cette structure nécessite N + 1 interrupteurs pilotés pour N actionneurs magnétostrictifs, auxquels s'ajoute une seule diode.

Dans un mode particulier de réalisation, le circuit de contrôle travaille à fréquence variable avec une limitation de la fréquence d'ondulation de la forme d'onde.

Particulièrement quand le dispositif de l'invention est adapté à plusieurs actionneurs magnétostrictifs, au moins une partie mécanique d'un actionneur magnétostrictif est associé à un injecteur d'un moteur à combustion interne.

**Revendications**

1. Procédé de commande d'au moins un actionneur magnétostrictif du genre comportant une partie électrique, notamment de type inductif, et qui est destinée à être alimentée électriquement et une partie mécanique dont une partie mécanique mobile peut être maintenue dans une position de travail relativement à une partie mécanique fixe, **caractérisé en ce qu'**il comporte les étapes de :

   -- détecter le courant électrique traversant la partie électrique de l'actionneur magnétostrictif (2, 14) ;
   -- modifier l'amplitude et/ou la fréquence de la forme d'onde d'alimentation électrique en fonction de la détection du courant électrique traversant la partie électrique de l'actionneur ;

   en répétant le procédé pendant au moins une partie d'une étape de maintien de la position de travail de la partie mécanique mobile de l'actionneur magnétostrictif.

2. Procédé selon la revendication 1, **caractérisé en ce que** l'étape de détection du courant électrique traversant la partie électrique de l'actionneur magnétostrictif comporte une étape de détection du passage d'un niveau de courant très bas à travers la partie électrique de l'actionneur, à l'issue de laquelle on exécute l'étape de modification de l'amplitude et/ou de la fréquence de la forme d'onde d'alimentation, le niveau très bas étant choisi inférieur au niveau bas du niveau de courant traversant la partie électrique de l'actionneur lors de l'étape de maintien.

3. Procédé selon la revendication 2, **caractérisé en ce que** l'étape de détection du courant électrique traversant la partie électrique de l'actionneur magnétostrictif comporte une étape de détection du passage d'un niveau de courant bas supérieur au dit niveau de courant très bas, et détection du passage d'un niveau de courant haut à travers la partie électrique de l'actionneur et **en ce que** l'étape de modification de l'amplitude et/ou de la fréquence de la forme d'onde d'alimentation comporte une étape pour augmenter le niveau de courant si on détecte un niveau de courant bas et pour diminuer le niveau de courant si on détecte un niveau de courant haut.

4. Procédé selon l'une quelconque des revendications précédentes, **caractérisé en ce qu'**il comporte une étape pour modifier la fréquence d'alimentation de la partie électrique.

5. Dispositif de contrôle d'au moins un actionneur magnétostrictif pour mettre en oeuvre le procédé selon l'une quelconque des revendications précédentes, **caractérisé en ce qu'**il comporte :

   -- un pont d'alimentation électrique (3) comportant au moins un composant actif (I1 ; I1, I2) et connecté d'une part à une source de tension électrique (E) et d'autre part à la partie électrique de l'actionneur magnétostrictif (2, 14) ;
   -- un capteur (5) pour détecter le courant électrique traversant la partie électrique de l'actionneur magnétostrictif ;
   -- un calculateur (15) pour commander les composants actifs du pont d'alimentation électrique en fonction du signal produit par le capteur pour détecter le courant électrique traversant la partie électrique de l'actionneur magnétostrictif (2, 14) de façon à adapter l'amplitude et/ou la fréquence de la forme d'onde d'alimentation électrique de l'actionneur magnétostrictif.

6. Dispositif selon la revendication 5, **caractérisé en ce que** le capteur (5) est connecté à un circuit (6 - 11) de détection du niveau de courant traversant la partie électrique d'au moins un actionneur magnétostrictif.

7. Dispositif selon la revendication 6, **caractérisé en ce que** le pont comporte au moins un interrupteur contrôlé (I1 ; I1, I2) et au moins une diode (D1 ; D1, D2) et **en ce qu'**il comporte au moins trois branches.

8. Dispositif selon l'une quelconque des revendications 6 ou 7, **caractérisé en ce que** le calculateur est connecté au circuit (C) de détection du niveau de courant et **en ce qu'**il comporte un moyen pour exécuter une machine d'état (15) reproduisant les étapes du procédé en fonction des niveaux de courant détectés par le circuit de détection (6 - 11), le pont d'alimentation comportant deux interrupteurs contrôlés (I1, I2) et étant contrôlé en fonction de l'exécution de la machine d'état, la machine d'état prenant une pluralité d'états successifs parmi lesquels :

- un état « état 5 » lorsque un défaut est détecté, un signal de réinitialisation faisant passer la machine d'état de l'état « état 5 » à un état « état 0 » ;
- un état « état 0 » dans lequel les interrupteurs I1 et I2 sont ouverts, la transition vers un état actif d'un indicateur de mise en conduction ON faisant passer la machine d'état de l'état « état 0 » à un état « état 1 » ;
- un état « état 1 » dans lequel les interrupteurs I1 et I2 sont tous les deux placés en conduction, la transition vers un état actif de l'indicateur de mise en conduction ON faisant passer la machine d'état de l'état « état 1 » à un état « état 4 » et si un indicateur de détection du seuil bas DSB est à "1", la machine d'état passe de l'état « état 1 » à un état « état 2 » ;
- un état « état 2 » dans lequel les interrupteurs les interrupteurs I1 et I2 sont fermés, la détection (DSH) d'un seuil haut du courant traversant l'actionneur faisant passer la machine d'état de l'état « état 2 » à un état « état 3 » ;
- un état « état 3 » dans lequel l'interrupteur I1 est ouvert et l'interrupteur I2 est en conduction, la détection d'un seuil bas (DSB) faisant passer la machine d'état de l'état « état 3 » à l'état « état 2 », et la désactivation du signal de mise en conduction ON faisant passer la machine d'état de l'état « état 3 » à l'état « état 4 » ;
- un état « état 4 » dans lequel les deux interrupteurs I1 et I2 sont placés à l'état ouvert, la détection d'un seuil très bas «(DSO) faisant passer la machine d'état de l'état « état 4 » à l'état « état 0 ».

9.  Dispositif selon l'une quelconque des revendications 5 à 8, **caractérisé en ce qu'**il comporte une pluralité de parties électriques d'actionneurs, chacune étant connectée par au moins une première et une seconde branches de pont d'alimentation à une première et une seconde bornes de la source d'alimentation.

10. Dispositif selon l'une quelconque des revendications 5 à 9, **caractérisé en ce qu'**au moins une partie mécanique d'un actionneur magnétostrictif est associé à un injecteur d'un moteur à combustion interne.

## Claims

1.  Method of controlling at least one magnetostrictive actuator of the type comprising an electrical part, in particular an inductive one, which part is designed to be electrically supplied, and a mechanical part, a movable mechanical part of which can be held in a working position relative to a stationary mechanical part, **characterized in that** it comprises the steps of:

- detecting the electric current passing through the electrical part of the magnetostrictive actuator (2, 14) ; and
- modifying the amplitude and/or the frequency of the waveform of the electric supply as a function of the detection of the electric current passing through the electrical part of the actuator,

while repeating the procedure during at least one part of a step of holding the movable mechanical part of the magnetostrictive actuator in the working position.

2.  Method according to Claim 1, **characterized in that** the step of detecting the electric current passing through the electrical part of the magnetostrictive actuator comprises a step of detecting the flow of a very low-level current through the electrical part of the actuator, which results in the step of modifying the amplitude and/or frequency of the supply waveform being carried out, the very low level being chosen to be less than the low level of current passing through the electrical part of the actuator during the holding step.

3.  Method according to Claim 2, **characterized in that** the step of detecting the electric current passing through the electrical part of the magnetostrictive actuator comprises a step of detecting the flow of a low-level current greater than said very low-level current, and detection of the flow of a high-level current through the electrical part of the actuator and **in that** the step of modifying the amplitude and/or frequency of the supply waveform comprises a step to increase the level of current if a low-level current is detected and to decrease the level of current if a high-level current is detected.

4.  Method according to any of the preceding claims, **characterized in that** it comprises a step to modify the supply frequency of the electrical part.

5.  Control device for at least one magnetostrictive actuator to implement the method according to any one of the preceding claims, **characterized in that** it comprises:

- an electric feeding bridge (3) comprising at least one active component (I1; I1, 12) and connected on the one hand to an electric voltage source (E) and on the other hand to the electrical part of the magnetostrictive actuator (2, 14);
- a sensor (5) to detect the electric current passing through the electrical part of the magnetostrictive actuator; and
- a calculator (15) to control the active components of the electric feeding bridge as a function of the signal produced by the sensor for detecting the electric current passing through the electrical part of the magnetostrictive actuator (2, 14) so as to adapt the amplitude and/or frequency of the waveform of the electric supply of the magnetostrictive actuator.

6. Device according to Claim 5, **characterized in that** the sensor (5) is connected to a circuit (6-11) for detecting the level of current passing through the electrical part of at least one magnetostrictive actuator.

7. Device according to Claim 6, **characterized in that** the bridge comprises at least one controlled switch (I1; I1, 12) and at least one diode (D1; D1, D2) and **in that** it comprises at least three arms.

8. Device according to either of Claims 7 and 8, **characterized in that** the calculator is connected to the circuit (C) for detecting the current level and **in that** it comprises a means for implementing a state machine (15) reproducing the steps of the method as a function of the current levels detected by the detection circuit (6-11), the feeding bridge comprising two controlled switches (I1, I2) and being controlled as a function of the implementation of the state machine, the state machine assuming a plurality of successive states among which:

   - a "state 5" state when a fault is detected, a reset signal causing the state machine in the "state 5" state to change to a "state 0" state;
   - a "state 0" state in which the switches I1 and I2 are open, the transition of a turn-on indicator to an active state causing the state machine in the "state 0" state to change to a "state 1" state;
   - a "state 1" state in which the switches I1 and 12 are both set to conduct, the transition of a turn-on indicator to an active state causing the state machine in the "state 1" state to change to a "state 4" state and, if a low threshold detection (LTD) indicator is at "1", the state machine changes from the "state 1" state to a "state 2" state;
   - a "state 2" state in which the switches I1 and I2 are closed, the detection of a high threshold (HTD) of current passing through the actuator causing the state machine in the "state 2" state to change to a "state 3" state;

   - a "state 3" state in which the switch I1 is open and the switch I2 is conducting, the detection of a low threshold (LTD) causing the state machine in the "state 3" state to change to the "state 2" state, and the deactivation of the turn-on signal causing the state machine in the "state 3" state to change to the "state 4" state; and
   - a "state 4" state in which the two switches I1 and I2 are set in the open state, the detection of a very low threshold (0TD) causing the state machine in the "state 4" state to change to the "state 0" state.

9. Device according to any one of Claims 5 to 8, **characterized in that** it comprises a plurality of electrical actuator parts, each being connected by at least a first and a second arm of the feeding bridge to a first and a second terminal of the power source.

10. Device according to any one of Claims 5 to 9, **characterized in that** at least one mechanical part of a magnetostrictive actuator is linked with an injector of an internal combustion engine.

## Patentansprüche

1. Verfahren zur Steuerung mindestens eines magnetostriktiven Aktors von der Art, der einen elektrischen Teil, insbesondere vom induktiven Typ, der dazu bestimmt ist, mit Strom versorgt zu werden, und einen mechanischen Teil aufweist, von dem ein beweglicher mechanischer Teil in einer Arbeitsstellung bezüglich eines ortsfesten mechanischen Teils gehalten werden kann, **dadurch gekennzeichnet, dass** es die folgenden Schritte aufweist:

   -- Erfassen des den elektrischen Teil des magnetostriktiven Aktors (2, 14) durchfließenden elektrischen Stroms;
   -- Verändern der Amplitude und/oder der Frequenz der Stromversorgungs-Wellenform in Abhängigkeit von der Erfassung des den elektrischen Teil des Aktors durchfließenden elektrischen Stroms;

   unter Wiederholung des Verfahrens während mindestens eines Teils eines Schritts der Aufrechterhaltung der Arbeitsstellung des beweglichen mechanischen Teils des magnetostriktiven Aktors.

2. Verfahren nach Anspruch 1, **dadurch gekennzeichnet, dass** der Schritt der Erfassung des den elektrischen Teil des magnetostriktiven Aktors durchfließenden elektrischen Stroms einen Schritt der Erfassung des Durchgangs eines sehr niedrigen Strompegels durch den elektrischen Teil des Aktors aufweist, nach dem der Schritt der Veränderung der Amplitude und/oder der Frequenz der Versorgungs-Wellenform durchgeführt wird, wobei der sehr niedrige Pegel geringer als der niedrige Pegel des Strompegels gewählt wird, der während des Aufrechterhaltungsschritts durch den elektrischen Teil des Aktors fließt.

3. Verfahren nach Anspruch 2, **dadurch gekennzeichnet, dass** der Schritt der Erfassung des durch den elektrischen Teil des magnetostriktiven Aktors fließenden elektrischen Stroms einen Schritt der Erfassung des Durchgangs eines niedrigen Strompegels höher als der sehr niedrige Strompegel und die Erfassung des Durchgangs eines hohen Strompegels durch den elektrischen Teil des Aktors aufweist, und dass der Schritt der Veränderung der Amplitude und/oder der Frequenz der Versorgungs-Wellenform einen Schritt aufweist, um den Strompegel zu erhöhen, wenn ein niedriger Strompegel erfasst wird, und um den Strompegel zu senken, wenn ein hoher Strompegel erfasst wird.

4. Verfahren nach einem der vorhergehenden Ansprüche, **dadurch gekennzeichnet, dass** es einen Schritt aufweist, um die Versorgungsfrequenz des elektrischen Teils zu verändern.

5. Vorrichtung zur Steuerung mindestens eines magnetostriktiven Aktors zur Anwendung des Verfahrens nach einem der vorhergehenden Ansprüche, **dadurch gekennzeichnet, dass** sie aufweist:

    -- eine elektrische Speisebrücke (3), die mindestens ein aktives Element (I1; I1, I2) aufweist und einerseits mit einer Quelle elektrischer Spannung (E) und andererseits mit dem elektrischen Teil des magnetostriktiven Aktors (2, 14) verbunden ist;
    -- einen Sensor (5) zur Erfassung des elektrischen Stroms, der durch den elektrischen Teil des magnetostriktiven Aktors fließt;
    -- einen Rechner (15), um die aktiven Elemente der Speisebrücke in Abhängigkeit von dem vom Sensor erzeugten Signal zu steuern, um den elektrischen Strom zu erfassen, der durch den elektrischen Teil des magnetostriktiven Aktors (2, 14) fließt, um die Amplitude und/oder die Frequenz der Stromversorgungs-Wellenform des magnetostriktiven Aktors anzupassen.

6. Vorrichtung nach Anspruch 5, **dadurch gekennzeichnet, dass** der Sensor (5) mit einer Schaltung (6 - 11) zur Erfassung des Strompegels verbunden ist, der durch den elektrischen Teil mindestens eines magnetostriktiven Aktors fließt.

7. Vorrichtung nach Anspruch 6, **dadurch gekennzeichnet, dass** die Brücke mindestens einen gesteuerten Unterbrecher (I1; I1, I2) und mindestens eine Diode (D1; D1, D2) aufweist und dass sie mindestens drei Zweige aufweist.

8. Vorrichtung nach einem der Ansprüche 6 oder 7, **dadurch gekennzeichnet, dass** der Rechner mit der Schaltung (C) zur Erfassung des Strompegels verbunden ist und dass er ein Mittel aufweist, um eine Zustandsmaschine (15) auszuführen, die die Schritte des Verfahrens in Abhängigkeit von den durch die Erfassungsschaltung (6 - 11) erfassten Strompegel reproduziert, wobei die Speisebrücke zwei gesteuerte Unterbrecher (I1, I2) aufweist und in Abhängigkeit von der Ausführung der Zustandsmaschine gesteuert wird, wobei die Zustandsmaschine mehrere aufeinanderfolgende Zustände annimmt, darunter

    - einen Zustand "Zustand 5", wenn ein Fehler erfasst wird, wobei ein Reset-Signal die Zustandsmaschine vom Zustand "Zustand 5" in einen Zustand "Zustand 0" übergehen lässt;
    - einen Zustand "Zustand 0", in dem die Schalter I1 und I2 offen sind, wobei der Übergang eines Einschaltungsanzeigers ON in einen aktiven Zustand die Zustandsmaschine vom Zustand "Zustand 0" in einen Zustand "Zustand 1" übergehen lässt;
    - einen Zustand "Zustand 1", in dem die Schalter I1 und 12 beide in der leitenden Stellung sind, wobei der Übergang des Einschaltungsanzeigers ON in einen aktiven Zustand die Zustandsmaschine vom Zustand "Zustand 1" in einen Zustand "Zustand 4" übergehen lässt, und wenn ein Erfassungsanzeiger des niedrigen Pegels DSB auf "1" ist, die Zustandsmaschine vom Zustand "Zustand 1" in einen Zustand "Zustand 2" übergeht;
    - einen Zustand "Zustand 2", in dem die Schalter I1 und I2 geschlossen sind, wobei die Erfassung (DSH) eines hohen Pegels des durch den Aktor fließenden Stroms die Zustandsmaschine vom Zustand "Zustand 2" in einen Zustand "Zustand 3" übergehen lässt;
    - einen Zustand "Zustand 3", in dem der Schalter I1 offen und der Schalter I2 leitend ist, wobei die Erfassung eines niedrigen Pegels (DSB) die Zustandsmaschine vom Zustand "Zustand 3" in den Zustand "Zustand 2" übergehen lässt, und die Deaktivierung des Einschaltungssignals ON die Zustandsmaschine vom Zustand "Zustand 3" in den Zustand "Zustand 4" übergehen lässt;
    - einen Zustand "Zustand 4", in dem die zwei Unterbrecher I1 und I2 sich im offenen Zustand befinden, wobei die Erfassung eines sehr niedrigen Pegels (DS0) die Zustandsmaschine vom Zustand "Zustand 4" in den Zustand "Zustand 0" übergehen lässt.

**9.** Vorrichtung nach einem der Ansprüche 5 bis 8, **dadurch gekennzeichnet, dass** sie mehrere elektrische Teile von Aktoren aufweist, die je über mindestens einen ersten und einen zweiten Speisebrückenzweig mit einer ersten und einer zweiten Klemme der Speisequelle verbunden sind.

**10.** Vorrichtung nach einem der Ansprüche 5 bis 9, **dadurch gekennzeichnet, dass** mindestens ein mechanischer Teil eines magnetostriktiven Aktors einer Einspritzdüse eines Verbrennungsmotors zugeordnet ist.

**Fig. 1**

Commande d'actionnement
(début et fin):

**Fig. 2**

Fig. 3

Fig. 4

Fig. 5

Fig. 6

Fig. 7

Fig. 8

**Fig. 9**

**Fig. 10**

**Fig. 11**

**EP 1 657 759 B1**

**Documents brevets cités dans la description**

- EP 1420468 A